# EUROPÄISCHE PATENTSCHRIFT

(11) **EP 1 917 316 B1**
(45) Veröffentlichungstag und Bekanntmachung des Hinweises auf die Patenterteilung: **01.12.2010**
(21) Anmeldenummer: 06792954.7
(22) Anmeldetag: 23.08.2006
(51) Int. Cl.: C09D 163/00, H01B 3/40, C08G 59/24, C08G 59/68

(54) **ÜBERZUGSMASSE**
COATING MASS
MATIERE DE REVETEMENT

(30) Priorität: 25.08.2005 DE 102005040126
(43) Veröffentlichungstag der Anmeldung: 07.05.2008
(73) Patentinhaber: Altana Electrical Insulation GmbH, 46483 Wesel (DE)
(72) Erfinder: TÖDTER-KÖNIG, Sascha, 22763 Hamburg (DE); SCHMIDT, Gerold, 22145 Hamburg (DE); LIENERT, Klaus-W., 22763 Hamburg (DE)
(74) Vertreter: Fitzner, Uwe
(86) Internationale Anmeldenummer: PCT/EP2006/065572
(87) Internationale Veröffentlichungsnummer: WO 2007/023165

(56) Entgegenhaltungen:
- EP-A2- 0 307 665
- WO-A-2005/081266
- US-A- 4 238 587
- US-A- 5 043 221
- US-A- 5 932 682
- DATABASE WPI Week 199607 Derwent Publications Ltd., London, GB; AN 1990-257621 XP002409820 & JP 08 002939 B (KANSAI PAINT CO LTD) 17. Januar 1996 (1996-01-17)

## Beschreibung

Diese Anmeldung nimmt die Priorität der DE 10 2005 040 126.0-43 in Anspruch.

Die vorliegende Erfindung betrifft ein Verfahren zur Beschichtung von Thermolabilen Substraten, in dem eine Überzugsmasse für thermolabile Substrate auf das Substrat appliziert wird, insbesondere im Bereich der Flachbaugruppen, Hybride und SMD-Baugruppen und bestickten Leiterplatten.

Eine Überzugsmasse für Flachbaugruppen, Hybriden, SMD-Baugruppen, sowie andere Komponenten, die auf Leiterplatten zum Einsatz kommen, muß die beschichteten Teile vor Feuchte, Chemikalien, Staub usw. schützen können. Außerdem sollte durch die Schutzschicht die Klima- und Kriechstromsicherheit elektronischer Baugruppen erhöht werden. Die thermische Belastbarkeit muß dem Einsatzgebiet angepaßt sein. Eine gute Haftung auf verschiedenen Substraten wird als selbstverständlich angenommen. Die Verarbeitung geschieht üblicherweise im Select Coat- oder Selektivtauchverfahren. Wird die Temperatur der Masse erhöht, um die Viskosität zu reduzieren, können sowohl Sprüh- als auch Spritzverfahren zum Einsatz kommen. Mit einer derartigen Überzugsmasse werden ausgezeichnete Trockenfilme in Stärken bis zu einigen Millimetern erhalten.

Stand der Technik ist die Verwendung von luft- oder ofentrocknenden Lacken. Das Bindemittel ist üblicherweise ein Alkyd-, oder ein Acryl-, oder ein Polyurethanharz. Diese Lacke sind als Oberflächenschutz seit langem bekannt und auch beschrieben (W. Tillar Shugg, Handbook of Electrical and Electronic Insulating Materials, IEEE Press 1995). Üblicherweise enthalten die Lacke bis zu fünfzig oder mehr Prozent Lösemittel. Die Lösemittel werden beim Härten an die Umgebungsluft abgegeben, was heute unerwünscht ist. Lösemittelsysteme für diesen Einsatz sind Formulierungen auf Basis von Polythan- und Epoxidharzen.

Die Härtungsmechanismen der einkomponentigen Epoxidharze, die durch LewisSäuren polymerisieren, sind in der Literatur ausführlich beschrieben (S.A.Zahir, E.Hubler, D.Baumann, Th.Haug, K.Meier, Polymere, S. 273, B.G.Teubner Stuttgart 1997).

In der US 6,297,344 und in der US 6,207,732 werden einkomponentige Epoxidharze beschrieben, die als Kleber eingesetzt werden. Die Härtungstemperatur beträgt 120°C.

In der WO 94/10223 werden epoxidharzhaltige Formulierungen beschrieben, die zuerst mit UV-Licht aktiviert werden und nachher thermisch bei 150°C in einer Stunde gehärtet werden. Anwendungen sind Vergießen, Abdecken und Verkleben von elektrischen und elektronischen Bauelementen.

In der US 20030200701 werden Formulierungen beschrieben, die bei 140°C ausgehärtet werden.

Die vorliegende Erfindung hat sich die Aufgabe gestellt, eine niedrigviskose Überzugsmasse zur Beschichtung von thermolabilen Substraten, beispielsweise von Flachbaugruppen, z.B. Leiterplatten, Hybriden, z.B. hybride Mikrosysteme, SMD-Baugruppen, usw. zur Verfügung zu stellen, die geringe thermische Härtungsenergie und die weniger Härtungszeit als der bisherige Stand der Technik erfordern, und die sich auf den üblichen Anlagen verarbeiten läßt, und die als Schutzbeschichtung einsetzbar ist.

Diese Aufgabe wird gelöst durch eine Überzugsmasse enthaltend Bindemittel oder Bindemittelgemische, welche oberhalb von 60°C und unterhalb von 120°C härtbar sind. Besonders bevorzugt sind Bindemittel oder Bindemittelgemische welche bei 70°C -110°C, insbesondere bei 80°C - 90°C härtbar sind. Die Überzugsmasse enthält als Bindemittel Epoxidharze und als Katalysator quartäre Amoniumhexafluorantimonate.

Vorzugsweise enthält die erfindungsgemäße Überzugsmasse mehrere Katalysatoren, welche eine Härtung der Überzugsmasse oberhalb von 60°C und unterhalb von 120°C, vorzugsweise bei 70°C - 110°C, insbesondere bei 80°C - 90°C ermöglichen. Erfindungsgemäß kommen Katalysatoren zum Einsatz, welche eine Härtung bei den angegebenen Temperaturen innerhalb von 50 Minuten, vorzugsweise 30 Minuten ermöglichen. Besonders bevorzugt sind solche Katalysatoren, die eine Härtung innerhalb von 20 - 50 Minuten, ganz besonders bevorzugt innerhalb von 25 - 40 Minuten ermöglichen.

Außer den genannten Bindemitteln und Katalysatoren kann die Überzugsmasse weitere übliche Hilfs- und Zusatzkomponenten enthalten.

Erfindungsgemäß besonders bevorzugt ist eine Überzugsmasse enthaltend die Komponenten A, B, C und ggf. D, wobei
die Komponente A
a) wenigstens ein Bindemittel enthält,
   die Komponente B
b) einen oder mehrere Reaktivverdünner
   die Komponente C
c) quartäre Amoniumhexafluorantimonate als Katalysator, der eine Härtung der erfindungsgemäßen Überzugsmasse bei 60°C -120°C, bevorzugt 70°C - 110°C, insbesondere bei 80 - 90°C ermöglicht,
   und die Komponente D
d) einen oder mehrere Stoffe, ausgewählt aus der Gruppe bestehend aus Korrosionsinhibitoren, Entschäumern, Verlaufs- und Netzmitteln
   enthalten.

In einer erfindungsgemäß bevorzugten Ausführungsform kann das Überzugsmittel aus den Komponenten A bis D bestehen. Ebenso ist es möglich, daß die Komponente B aus einem Reaktivverdünner, die Komponente C aus einem Härtungskatalysator und die Komponente D aus den genannten Korrosionsinhibitoren, Entschäumern, Verlaufsmitteln und Netzmitteln besteht.

Erfindungsgemäß enthält die Komponente A vorzugsweise ein Bindemittel aus der Klasse der cycloaliphatischen Diepoxidharze. Besonders bevorzugt ist, daß die Komponente aus derartigen Harzen besteht. Beispiele dieser Harze, sind Bis(3,4-Epoxycyclohexylmethyl)adipat oder 3,4-Epoxycyclohexylmethyl-3,4-epoxycyclohexancarboxylat. Die Harze können allein oder in Mischung eingesetzt werden. Außer den genannten Harzen kommen auch Bindemittel in Betracht, welche ähnliche Eigenschaften aufweisen. D.h. die Bindemittel müssen jeweils allein oder im Gemisch, oder in Gegenwart eines Katalysators geeignet sein, oberhalb von 60°C und unterhalb von 120°C, vorzugsweise bei 70°C - 110°C, insbesondere bei 80°C - 90 °C auszuhärten.

Als Komponente B kommen vorzugsweise Verbindungen in Betracht, die mit den erfindungsgemäßen Epoxidharzen kationisch copolymeriseren. Solche Verbindungen können beispielsweise Monoexpoxide sein, wie z.B. Limonenoxid, außerdem Epoxinovolake. Ebenso können Polyole des Typs Polyethylen- oder Polypropylenglykol mit linearen oder verzweigten Strukturen, Homo- oder Copolymerisate eingesetzt werden. Außerdem sind natürlich vorkommende OH-funtionalisierte Öle, z.B. Rizinusöl verwendbar. Vinylether, wie Triethylenglykol- oder Cyclohexandimethanoldivinylether sind ebenfalls einsetzbar. Ferner kommen Alkylencarbonate, wie z.B. Propylencarbonat in Betracht. Geeignet sind erfindungsgemäß auch Oxetane als Reaktivverdünner für Epoxidharze, wie z.B. 3-Ethyl-hydroxymethyloxetan, Terephthalatbisoxetan oder Bisphenylenbisoxetan.

Die Komponente C enthält wenigstens einen Katalysator, welcher geeignet ist, die Überzugsmittel bei Temperaturen oberhalb von 60°C und unterhalb von 120°C, vorzugsweise bei 70°C - 110°C, insbesondere bei 80°C - 90°C auszuhärten. Die Härtungskatalysatoren sollen eine Aushärtung vorzugsweise innerhalb von 50 Minuten ermöglichen. Besonders bevorzugt ins eine Aushärtung innerhalb von 20 - 50 Minuten, ganz bevorzugt innerhalb von 25 - 40 Minuten, höchst bevorzugt innerhalb von 30 Minuten. Erfindungsgemäß bevorzugt ist es, quartäre Amoniumhexafluorantimonate einzusetzen. Bevorzugt wird hierbei der Einsatz von (4-Methoxybenzyl)dimethylphenylammoniumhexafluoroantimonat als Härtungskatalysator verwendet. Er erlaubt eine Härtung der erfindungsgemäßen Überzugsmasse bei den oben angegebenen Temperaturen und innerhalb der angegebenen Zeitspannen.

Die Komponente D enthält einen oder mehrere Stoffe ausgewählt aus der Gruppe bestehend aus Korrosionsinhibitoren, Entschäumern, Verlaufs- und Netzmitteln.

Die erfindungsgemäße Überzugsmasse kann dadurch hergestellt werden, daß die Komponenten A bis D miteinander vermischt werden und anschließend gelagert oder ihrer Verwendung zugeführt werden. Versuche haben gezeigt, daß die erfindungsgemäßen Überzugsmassen über Wochen lagerstabil sind. Erfindungsgemäß wird epoxidharzhaltiges Bindemittel gemäß Komponente A mit den anderen Komponenten vorzugsweise homogen gemischt. Dadurch erhält man eine Überzugsmasse, die abhängig von der Zusammensetzung unterschiedliche Viskositäten haben kann. Üblicherweise haben Überzugsmassen die zum Beschichten von Flachbaugruppen in der Elektronik, Hybriden und SMD-Baugruppen dienen, Viskositäten zwischen 300 mPa.s und 600 mPa.s gemessen bei 25°C, je nach Anwendung, Verarbeitungstechnologie, und gewünschter Schichtstärke. Die erfindungsgemäße Überzugsmasse ist insbesondere für den Überzug von Flachbaugruppen in der Elektronik, z.B. Leiterplatten, von Hybriden, z.B. hybriden Mikrosystemen und SMD-Baugruppen und auch bestückten Leiterplatten geeignet. Der Überzug hat eine hervorragende Haftung und ist VOC-frei bzw. VOC-arm. Außerdem kann darüber hinaus die erfindungsgemäße Überzugsmasse auch zum Tränken von elektrischen Wicklungen oder als Schutzlack für elektrische Wicklungen eingesetzt werden.

Nachfolgend wird die Erfindung unter Bezugnahme auf die Beispiele näher beschrieben. Die Ausprüfung erfolgt nach DIN und IEC-Normen. Die Eigenschaften der Lackfilme der Formulierungen aus dem Beispiel 1 und dem Vergleichsbeispiel 5 zeigen vergleichbare Werte. Das bedeutet, daß die Härtung mit dem erfindungsgemäßen Katalysator bei 90°C der Härtung gemäß bisherigem Stand der Technik bei 150°C gleichwertig ist.

### Beispiele

### Beispiel 1

Zu 2031,0 g 3,4-Epoxycyclohexylmethyl-3,4-epoxycyclohexancarboxylat werden 55,0g Lupranol^{®} 3300 (Polyetherpolyol der BASF) und eine Lösung von 7g (4-Methoxybenzyl)dimethylphenylammonium-hexafluoroantimonat in 7g Propylencarbonat unter Rühren hinzugefügt. Die Überzugsmasse war über Wochen lagerstabil und hatte eine Viskosität von 500mPas/Kegel/D bei 25°C.

Die Überzugsmasse härtet in Schichtdicken von 4 mm in 30 min bei 90°C einwandfrei aus. Die Härtungsverluste sind kleiner 0,1%. In einer Schichtstärke von 0,1 mm haftet der Lackfilm einwandfrei auf einem entfetteten Blech. Ein Dornbiegeversuch (3 mm) wird einwandfrei bestanden. Der Durchgangswiderstand beträgt bei 23°C 1,7 E+15 ohm*cm. Nach 7 Tagen Wasserlagerung beträgt der Durchgangswiderstand bei 23°C 1,8 E+14 ohm*cm. Die Durchschlagsfestigkeit ist 230 kV/mm (bei 23°C) und 228 kV/mm (bei 155°C).

Mit dem Lack werden Drillstäbe nach IEC 61033 (Methode A) getränkt und nach der Härtung (30 Minuten bei 90°C) wird die Verbackungsfestigkeit bestimmt. Sie beträgt bei 23°C 290 N.

### Beispiel 2

Aus 1722,0 g 3,4-Epoxycyclohexylmethyl-3,4-epoxycyclohexancarboxylat, 390,0 g Bis(3,4-Epoxycyclohexylmethyl)adipat, 210,0 g Lupranol^{®} 2042, 63,0 g Lupranol^{®} 3300 (Polyetherpolyole der BASF) und einer Lösung von (4-Methoxybenzyl)dimethylphenylammonium-hexafluoroantimonat in 7,9g Propylencarbonat werden unter Rühren homogen gemischt. Die Überzugsmasse war über Wochen lagerstabil und hatte eine Viskosität von 580 mPas bei 25°C.

Die Masse härtete in Schichtdicken von 4mm in 30 min/90°C im Umluftofen zu einem flexiblen Film aus. Die Härtungsverluste sind kleiner 0,2%. In einer Schichtstärke von 0,1 mm haftet der Lackfilm einwandfrei auf einem entfetteten Blech. Ein Dornbiegeversuch (3 mm) wird einwandfrei bestanden. Der Durchgangswiderstand beträgt bei 23°C 4,5 E+14 ohm*cm. Nach 7 Tagen Wasserlagerung beträgt der Durchgangswiderstand bei 23°C 8,5 E+13 ohm*cm. Die Durchschlagsfestigkeit ist 221 kV/mm (bei 23°C) und 210 kV/mm (bei 155°C)

Mit dem Lack werden Drillstäbe nach IEC 61033 (Methode A) getränkt und nach der Härtung (30 Minuten bei 90°C) wird die Verbackungsfestigkeit bestimmt. Sie beträgt bei 23°C 190 N.

### Beispiel 3

Aus 2100 g Bis(3,4-Epoxycyclohexylmethyl)adipat, 400,0g Lupranol^{®} 3530 (Polyetherpolyol der BASF) und einer Lösung von 12,5g (4-Methoxybenzyl) dimethylphenylammonium-hexafluoroantimonat in 12,5g Propylencarbonat wird eine Überzugsmasse unter Rühren hergestellt. Die Formulierung ist lagerstabil und hat eine Viskosität von 600 mPas/Kegel bei 25°C. In einer Schichtdicke von 4 mm in 30 min bei 90°C härtet sie im Umluftofen zu einem sehr flexiblen Film aus.

### Beispiel 4

Aus 1900 g Bis(3,4-Epoxycyclohexylmethyl)adipat, 600,0 g Rizinusöl und einer Lösung von 12,5g (4-Methoxybenzyl)dimethylphenylammonium-hexafluoroantimonatin in 12,5g Propylencarbonat wird unter Rühren eine Überzugsmasse hergestellt. Sie hat eine Viskosität von 600 mPas/Kegel bei 25°C. Die Masse härtete in einer Schichtdicke von 4mm in 30min bei 90°C im Umluftofen zu einem sehr flexiblen Film aus.

### Vergleichsbeispiel 5

Der Versuch aus Beispiel 1 wird wiederholt, nur daß als Katalysator ein handelsüblicher Bortrifluoridoctylaminkomplex verwendet wird.

Bei 90°C härtete die Masse, auch bei längerer Lagerung im Ofen, nicht aus. Die Masse härtete in 50 min bei 150°C im Umluftofen aus. Die Härtungsverluste sind in der Größenordnung von 1,8%. In einer Schichtstärke von 0,1 mm haftet der Lackfilm einwandfrei auf einem entfetteten Blech. Ein Dornbiegeversuch (3 mm) wird einwandfrei bestanden. Der Durchgangswiderstand beträgt bei 23°C 5,3 E+14 ohm*cm und nach 7 Tagen Wasserlagerung bei 23°C 1,1 E+13 ohm*cm. Die Durchschlagsfestigkeit beträgt jeweils 225 kV/mm (bei 23°C) und 212 kV/mm (bei 155°C).

## Patentansprüche

1. Verfahren zur Beschichtung von thermolabilen Substraten, indem eine Überzugsmasse für thermolabile Substrate auf das Substrat appliziert wird und bei Temperaturen von über 60°C und unter 120°C gehärtet wird, **dadurch gekennzeichnet, dass**
die Überzugsmasse wenigstens ein Bindemittel oder Bindemittelgemische, welche unterhalb von 120°C und oberhalb von 60°C härtbar sind, wobei
die Überzugsmasse als Bindemittel Epoxidharze enthält und
die Überzugsmasse als Katalysator quartäre Ammoniumhexafluorantimonate enthält.

2. Verfahren nach Anspruch 1, **dadurch gekennzeichnet, daß** die Bindemittel oder Bindemittelgemische bei 70°C - 110°C, insbesondere bei 80°C - 90°C härtbar sind.

3. Verfahren nach Anspruch 1 oder 2 **dadurch gekennzeichnet, daß** sie einen Härtungskatalysator enthält.

4. Verfahren nach einem der Ansprüche 1 bis 3 enthaltend wenigstens einen Reaktivverdünner und ggf. Korrosionsinhibitoren, Entschäumer, Verlaufs- und Nutzmittel.

5. Verfahren nach Anspruch 1 bis 4, **dadurch gekennzeichnet, daß** sie als Bindemittel cycloaliphatische Epoxidharze enthält.

6. Verfahren nach Anspruch 1 bis 5, **dadurch gekennzeichnet, daß** sie als Bindemittel Bis(3,4-Epoxycycloheximethyl)adipat oder 3,4-Epoxycyclohexylmethyl-3,4-epoxycyclohexan-carboxylat oder Gemische hiervon enthält.

7. Verfahren nach Anspruch 1 bis 6 **dadurch gekennzeichnet, daß** sie (4-Methoxybenzyl)dimethylphenylammonium-hexafluoroantimonat als Katalysator enthält.

8. Verfahren nach Anspruch 1 bis 7 **dadurch gekennzeichnet, daß** sie als Reaktivverdünner Verbindungen enthält, die mit Epoxidharzen kationisch polymerisieren.

9. Verfahren nach Anspruch 1 bis 8 **dadurch gekennzeichnet, daß** sie als Reaktivverdünner Monoepoxide, Polyole des Typs Polyethylen- oder Polypropylenglykol enthält.

10. Verfahren nach Anspruch 1 bis 9 **dadurch gekennzeichnet, daß** sie als Reaktivverdünner natürliche vorkommende OH-funktionalisierte Öle, vorzugsweise Rizinusöl enthält.

11. Verfahren nach einem der vorhergehenden Ansprüche **dadurch gekennzeichnet, daß** sie als Reaktivverdünner Vinylether, vorzugsweise Triethylenglykol- oder Cyclohexandimethanoldivinylether enthalten.

12. Verfahren nach Anspruch 1 bis 11 **dadurch gekennzeichnet, daß** sie als Reaktivverdünner Alkylencarbonate, vorzugsweise Propylencarbonat enthalten.

13. Verfahren nach Anspruch 1 bis 12 **dadurch gekennzeichnet, daß** sie Oxetane als Reaktivverdünner enthält, vorzugsweise 3-Ethyl-hydroxymethyloxetan, Terephthalatbisoxetan oder Bisphenylenbisoxetan enthalten.

14. Verfahren nach einem der vorhergehenden Ansprüche, **dadurch gekennzeichnet, dass** die thermolabilen Substrate Flachbaugruppen, Hybride, SMD-Baugruppen sind.

## Claims

1. Method of coating thermolabile substrates by applying a coating composition for thermolabile substrates to the substrate and curing it at temperatures of above 60°C and below 120°C, **characterized in that** the coating composition comprises at least one binder or binder mixtures which are curable below 120°C and above 60°C, the coating composition comprising epoxy resins as binders and the coating composition comprising quaternary ammonium hexafluoroantimonate as catalyst.

2. Method according to Claim 1, **characterized in that** the binders or binder mixtures are curable at 70°C-110°C, more particularly at 80°C-90°C.

3. Method according to Claim 1 or 2, **characterized in that** the coating composition comprises a curing catalyst.

4. Method according to any one of Claims 1 to 3, **characterized in that** the coating composition comprises at least one reactive diluent and, if desired, corrosion inhibitors, defoamers, flow control agents and wetting agents.

5. Method according to Claim 1 to 4, **characterized in that** the coating composition comprises cycloaliphatic epoxy resins as binders.

6. Method according to Claim 1 to 5, **characterized in that** the coating composition comprises bis(3,4-epoxycyclohexylmethyl) adipate or 3,4-epoxycyclohexylmethyl 3,4-epoxycyclohexanecarboxylate or mixtures thereof as binder(s).

7. Method according to Claim 1 to 6, **characterized in that** the coating composition comprises (4-methoxybenzyl)dimethylphenylammonium hexafluoroantimonate as catalyst.

8. Method according to Claim 1 to 7, **characterized in that** the coating composition comprises compounds which polymerize cationically with epoxy resins as reactive diluents.

9. Method according to Claim 1 to 8, **characterized in that** the coating composition comprises monoepoxides, polyols of the polyethylene glycol or polypropylene glycol type as reactive diluents.

10. Method according to Claim 1 to 9, **characterized in that** the coating composition comprises naturally occurring OH-functionalized oils, preferably castor oil, as reactive diluents.

11. Method according to any one of the preceding claims, **characterized in that** the coating composition comprises vinyl ethers, preferably triethylene glycol divinyl ether or cyclohexanedimethanol divinyl ether, as reactive diluents.

12. Method according to Claim 1 to 11, **characterized in that** the coating composition comprises alkylene carbonates, preferably propylene carbonate, as reactive diluents.

13. Method according to Claim 1 to 12, **characterized in that** the coating composition comprises oxetanes as reactive diluents, preferably 3-ethylhydroxymethyloxetane, terephthalatebisoxetane or bisphenylenebisoxetane.

14. Method according to any one of the preceding claims, **characterized in that** the thermolabile substrates are flat assemblies, hybrids, SMD assemblies.

## Revendications

1. Procédé pour l'enduction de subjectiles thermolabiles, par application d'une matière de revêtement pour subjectiles thermolabiles sur le subjectile et durcissement à des températures de plus de 60 °C et de moins de 120 °C, **caractérisé en ce que** la matière de revêtement contient au moins un liant ou mélange de liants, qui sont durcissables au-dessous de 120 °C et au-dessus de 60 °C,
la matière de revêtement contenant en tant que liant des résines époxy et
la matière de revêtement contenant en tant que catalyseur des hexafluoroantimonates d'ammonium quaternaire.

2. Procédé selon la revendication 1, **caractérisé en ce que** les liants ou mélanges de liants sont durcissables à 70 °C - 110 °C, en particulier à 80 °C - 90 °C.

3. Procédé selon la revendication 1 ou 2, **caractérisé en ce que** la matière de revêtement contient un catalyseur de durcissement.

4. Procédé selon l'une quelconque des revendications 1 à 3, **caractérisé en ce que** la matière de revêtement contient au moins un diluant réactif et éventuellement des agents anticorrosion, des antimousses, des agents d'étalement et des agents mouillants.

5. Procédé selon les revendications 1 à 4, **caractérisé en ce que** la matière de revêtement contient en tant que liant des résines époxy cycloaliphatiques.

6. Procédé selon les revendications 1 à 5, **caractérisé en ce que** la matière de revêtement contient en tant que liant de l'adipate de bis(3,4-époxycyclohexylméthyle) ou du carboxylate de 3,4-époxycyclohexylméthyl-3,4-époxycyclohexane ou des mélanges de ceux-ci.

7. Procédé selon les revendications 1 à 6, **caractérisé en ce que** la matière de revêtement contient en tant que catalyseur de l'hexafluoroantimonate de (4-méthoxybenzyl)diméthylphénylammonium.

8. Procédé selon les revendications 1 à 7, **caractérisé en ce que** la matière de revêtement contient en tant que diluant réactif des composés qui polymérisent par voie cationique avec des résines époxy.

9. Procédé selon les revendications 1 à 8, **caractérisé en ce que** la matière de revêtement contient en tant que diluant réactif des monoépoxydes, des polyols du type polyéthylèneglycol ou polypropylèneglycol.

10. Procédé selon les revendications 1 à 9, **caractérisé en ce que** la matière de revêtement contient en tant que diluant réactif des huiles à fonctionnalité OH existant dans la nature, de préférence de l'huile de ricin.

11. Procédé selon l'une quelconque des revendications précédentes, **caractérisé en ce que** la matière de revêtement contient en tant que diluant réactif des éthers vinyliques, de préférence de l'éther divinylique de triéthylèneglycol ou de cyclohexanediméthanol.

12. Procédé selon les revendications 1 à 11, **caractérisé en ce que** la matière de revêtement contient en tant que diluant réactif des carbonates d'alkylène, de préférence du carbonate de propylène.

13. Procédé selon les revendications 1 à 12, **caractérisé en ce que** la matière de revêtement contient en tant que diluant réactif des oxétanes, de préférence contient du 3-éthylhydroxyméthyloxétane, du téréphtalate-bisoxétane ou du bisphénylène-bisoxétane.

14. Procédé selon l'une quelconque des revendications précédentes, **caractérisé en ce que** les subjectiles thermolabiles sont des cartes à circuits imprimés, des circuits hybrides, des cartes à circuits imprimés SMD (à montage en surface).
